Europäisches Patentamt

European Patent Office

Office européen des brevets

(11) Veröffentlichungsnummer: **0 256 238**
**A2**

(12) **EUROPÄISCHE PATENTANMELDUNG**

(21) Anmeldenummer: **87108283.0**

(22) Anmeldetag: **09.06.87**

(51) Int. Cl.4: **C30B 7/02**

(30) Priorität: **16.08.86 DE 3627810**

(43) Veröffentlichungstag der Anmeldung:
**24.02.88 Patentblatt 88/08**

(84) Benannte Vertragsstaaten:
**BE CH DE FR GB IT LI NL SE**

(71) Anmelder: **Battelle-Institut e.V.**
**Am Römerhof 35 Postfach 900 160**
**D-6000 Frankfurt/Main 90(DE)**

(72) Erfinder: **Lierke, Ernst-Günter, Dr.**
**Westring 13**
**D-6131 Schwalbach/Ts.(DE)**
Erfinder: **Grossbach, Rudolf, Dipl.-Ing.**
**Horstweg 15**
**D-6277 Bad Camberg 2(DE)**
Erfinder: **Heide, Wolfgang M., Dipl.-Ing.**
**Elisabethenstrasse 38**
**D-6100 Darmstadt(DE)**
Erfinder: **Lühmann, Klaus-Dieter, Dipl.-Ing.**
**Nackenheimerstrasse 7**
**D-6090 Rüsselheim(DE)**

(54) **Verfahren und Vorrichtung zur Herstellung von Einkristallen.**

(57) Einkristalle werden aus einem Flüssigkeitstropfen berührungslos gezüchtet, der in einem stehenden Schall-oder Ultraschallfeld in der Schwebe gehalten wird.

EP 0 256 238 A2

## Verfahren und Vorrichtung zur Herstellung von Einkristallen

Die Erfindung betrifft ein Verfahren und eine Vorrichtung zur Herstellung von Einkristallen durch Verdunsten von Lösungsmitteln und/oder mittels Fällungsreaktionen.

Für viele Verbindungen sind Einkristalle sehr schwer zu züchten. Des öfteren entsteht auf der Innenwand des Kristallisationsgefäßes ein polykristalliner Rasen, von dem sich die einzelnen Kristalle ohne Zerstörung ihrer Struktur nicht mehr entfernen lassen.

Einkristalle sind insbesondere für die Röntgenstrukturanalyse, die zur Aufklärung der Kristallstruktur eine eindeutige Methode darstellt, von Bedeutung. Indirekte Methoden der Strukturaufklärung, wie NMR-, IR-oder Massenspektroskopie, sind fast nicht geeignet, wenn es darum geht, Strukturen neuartiger oder sehr komplexer Moleküle zu bestimmen, für die noch keine Modellvorstellungen existieren.

Der vorliegenden Erfindung liegt die Aufgabe zugrunde, eine Möglichkeit zur Züchtung von unbeschädigten Einkristallen von ausreichender Größe aufzuzeigen.

Diese Aufgabe ist erfindungsgemäß dadurch gelöst, daß der Einkristall aus einem, in einem stehenden Schall-oder Ultraschallfeld in der Schwebe gehaltenen Flüssigkeitstropfen berührungslos gezüchtet wird. Die Patentansprüche 2 bis 9 betreffen bevorzugte Ausführungsformen dieses Verfahrens.

Die erfindungsgemäße Vorrichtung zur Züchtung von Einkristallen besteht im wesentlichen aus einer Kammer, in der stehende Schall-oder Ultraschallfelder erzeugbar sind und die mit Einrichtungen zur Einführung eines im stehenden Schall-oder Ultraschallfeld zu positionierenden Flüssigkeitstropfens versehen ist. Die Patentansprüche 11 bis 19 haben die bevorzugten Weiterbildungen dieser Vorrichtung zum Gegenstand.

Die Positionierung von Flüssigkeitstropfen und festen Proben mittels stehender Schall-oder Ultraschallwellen ist bekannt. Das Verfahren beruht auf der Kraftwirkung intensiver stehender Schall-oder Ultraschallwellen, die feste oder flüssige Proben in die Druckknoten bzw. Schnellebäuche treibt, wo stabiles Gleichgewicht herrscht.

Stehende Ultraschallwellen können z. B. erzeugt werden, mittels eines kolbenmembranförmig abstrahlenden Ultraschallwandlers und eines in n λ/2 Abstand justierten Reflektors durch Vielfachreflexionen. Zur Positionierung von Proben sind jedoch sehr hohe Schallpegel erforderlich, wodurch unerwünschte Nebeneffekte, wie Tropfenrotation, Deformation bis zur Disintegration, d. h. Zerstäubung, und innere Turbulenzen auftreten können. Es ist trotzdem möglich Tropfen, z. B. zwischen 1 bis 8 mm Durchmesser, mit Ultraschallwellen von 20 kHz und 16 mm Wellenlänge in der Luft zu positionieren. Durch stehende Ultraschallwellen mit Schallpegeln von > 165 dB kann man Flüssigkeitstropfen mit Durchmessern $d \approx \lambda/2$ (=8mm) in den Druckknoten berührungslos schwebend halten, wobei die volumenspezifische Haltekraft bei abnehmendem Durchmesser d anwächst.

Wegen des großen Impedanzunterschieds zwischen dem positionierten Tropfen und dem Trägermedium dringt praktisch keine Schallenergie in den schwebenden Tropfen ein, so daß dessen Inneres ohne Wandeinfluß völlig ruhig bleibt. Voraussetzung hierfür ist, daß keine Gasblasen im Tropfen eingeschlossen sind und der Schallpegel nicht größer ist als notwendig.

Bei erhöhtem Schallpegel deformiert sich der schwebende Tropfen infolge des axial einwirkenden, zum Tropfenzentrum weisenden Strahlungsdrucks und der radial nach außen wirkenden Bernoulli-Kräfte, um schließlich bei überkritischen Schallpegeln zu zerstäuben. Der Bereich zwischen dem zum Positionieren erforderlichen Mindestschallpegel und dem kritischen Schallpegel der Zerstäubung hängt vom Tropfendurchmesser d und von dem Verhältnis $\delta/\rho$ aus Oberflächenspannung $\delta$ des Tropfens und Dichte $\rho$ der Flüssigkeit ab. Je größer der Durchmesser und je kleiner das Verhältnis $\delta/\rho$ ist, desto schwieriger ist es, Tropfen ungestört im stehenden Ultraschallfeld zu positionieren. In solchen Fällen muß das erfindungsgemäße Verfahren unter Schwerelosigkeit, z. B. im Weltraum, durchgeführt werden.

Sind in dem zu positionierenden Tropfen Substanzen gelöst, die durch Lösungsmittelverdunsten infolge Übersättigung ausfallen oder durch chemische Reaktion mit einer weiteren flüssigen Komponente auskristallisieren, so läßt sich durch geeignete Prozeßsteuerung, was insbesondere die Geschwindigkeit der Übersättigung betrifft, aus der Lösung ein Kritall züchten, der wegen des fehlenden Wandkontaktes, d. h. ohne heterogene Keimbildung, mit einer perfekten Kristallstruktur ungestört wachsen kann.

Bei schwer löslichen Substanzen, z. B. Farbpigmenten, wäre der aus einem Tropfen von 8 mm Durchmesser erzeugte Kristall zu klein, um aussagekräftige Röntgenstrukturuntersuchungen durchzuführen. In diesem Fall wird das abdampfende Lösungsmittel kontinuierlich oder diskontinuierlich durch nachgelieferte Lösung ersetzt, was mittels Bernoulli-Kräfte ohne Schwierigkeiten berührungslos möglich ist. Dies kann z. B. dadurch geschehen, daß in das Trägermedium Lösungsmittel dampf eingeleitet wird oder in der Prozeßkammer ein Lösungsmittelreservoir vorgesehen wird, aus dem durch entsprechende Druck- und/oder Temperaturvariation ein Abdampfen des Lösungsmittels stattfindet. Die Partialdrücke der in der Kammer befindlichen Gase werden zu diesem Zweck vorzugsweise kontinuierlich gemessen. Die weitere Nachlieferung der Lösung kann auch durch einen ständigen Kontakt zwischen dem - schwebenden Tropfen und der Flüssigkeitszuführungskanüle geschehen.

Eine weitere Möglichkeit, in einem Lösungstropfen die Kristallisation einzuleiten, besteht in einer direkten gezielten Erwärmung des Tropfens. Dies kann z. B. durch den Einsatz eines Laserstrahls erfolgen, der jedoch vorzugsweise derart geführt wird, daß er den Tropfen tangential nur an einem Randpunkt berührt.

Bei Fällungsreaktionen kann gemäß einer Ausführungsform des erfindungsgemäßen Verfahrens die eine flüssige Komponente im stehenden Schall-oder Ultraschallfeld positioniert werden, während die zweite flüssige Reaktionskomponente ebenfalls als Tropfen akustisch mit dem positionierten Tropfen zusammengebracht wird. Die zweite Reaktionskomponente wird vorzugsweise durch Kapillarwellenzerstäubung vom Positionierungswandler zerstäubt und in Form vieler Tröpfchen von z. B. 4 µm Durchmesser durch akustische Koagulation in der stehenden Welle auf dem Haupttropfen abgeschieden.

Anstelle des gasförmigen Trägermediums kann auch eine zweite Flüssigkeit eingesetzt werden, die mit der zu positionierenden Flüssigkeitstropfen nicht mischbar ist, die aber z.B. eine geringfügige, temperaturabhängige Löslichkeit besitzt, so daß durch Temperatur und/oder Druckvariation eine Übersättigung und damit Kristallisation eintritt. Diese durch Diffusionsvorgänge bestimmte Variante für binäre oder ternäre Flüssigkeiten erfordert eine modifizierte Technologie, weil an der Phasengrenzfläche wegen des geringeren Impedanzunterschieds zu erwarten ist, daß Energie in den positionierten Tropfen übertritt.

Die Erfindung wird anhand der schematischen Zeichnung näher erläutert. Es zeigt:

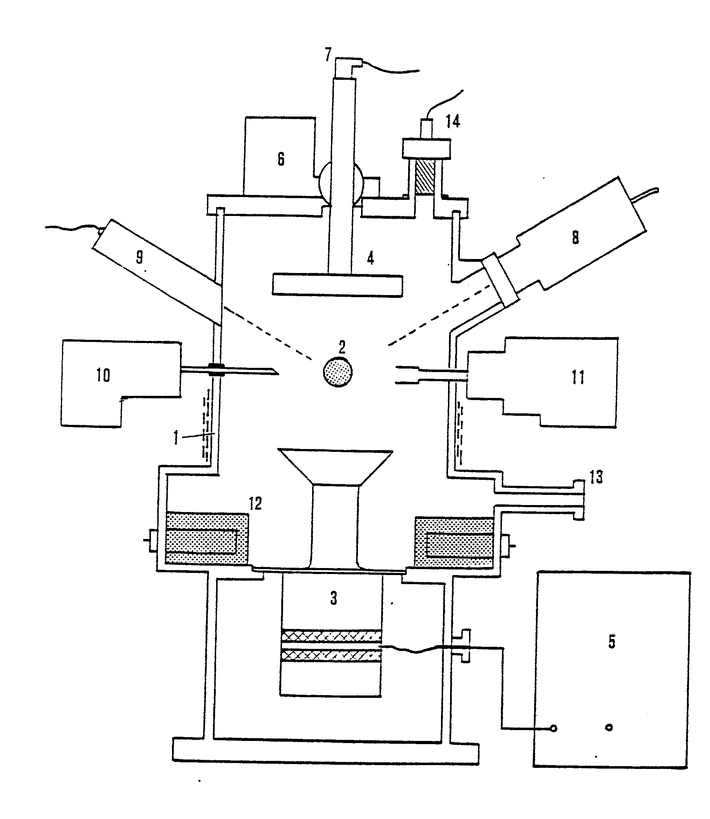

Fig. 1 eine Ausführungsform der erfindungsgemäßen Vorrichtung zur Einkristall-Züchtung aus einem in der stehenden Ultraschallwelle - schwebenden Flüssigkeitstropfen.

Die Vorrichtung besteht aus einer, vorzugsweise thermostatisierten Kammer 1. Der Flüssigkeitstropfen 2 wird mittels eines $\lambda/2$-Resonators 3 mit piezoelektrischer Anregung, Amplitudentransformation, Knotenhalterung und eines im Abstand dazu angeordneten Reflektors 4 positioniert. Der Resonator 3 steht mit dem Ultraschallgenerator 5 in Verbindung, der zur Reflektorabstimmung eine Phasensteuerung aufweist. Der Reflektor 4 ist vorzugsweise in axialer Richtung verschiebbar und mit einem Kugelgelenk zur Kippstellung versehen. Diese Verstellung wird mittels eines Motors 6 bewirkt. Ferner wird im Reflektor 4 ein Schallsensor 7 integriert, um die Phasenregelung der Stehwellenresonanz vorzunehmen.

Die Kammer 1 wird mit Sichtfenstern zur Probenbeobachtung, z. B. mittels einer CCD-Kamera 8, sowie zur Probenbeleuchtung 9 versehen.

Der Flüssigkeitstropfen 2 wird in diesem Beispiel durch eine Kanüle 10 in die stehende Welle geführt. Der gezüchtete Ein kristall kann mittels einer weiteren Kanüle 11 mit entsprechendem Durchmesser abgesaugt werden.

Zur Variation des Lösungsmitteldampfdrucks in der Kammer 1 werden ferner Lösungsmittelreservoire 12 vorgesehen, die vorzugsweise separat beheizbar oder abkühlbar sind. Über einen Pumpstutzen 13 kann der Lösungsmitteldampf kontrolliert abgepumpt werden, nachdem durch Drucksensoren 14 eine kontinuierliche Bestimmung der Partialdrücke der in der Kammer 1 befindlilichen Gase vorgenommen wird.

Mit einer solchen Vorrichtung lassen sich z. B. wässrige Lösungen von organischen oder anorganischen Substanzen als Tropfen von 5 bis 20 mm Durchmesser positionieren. Der Tropfendurchmesser d hängt dabei von der gewählten Wellenlänge $\lambda$ des Positionierers ab ($d < 2/3\lambda$). Als Trägermedium werden vorzugsweise Edelgase verwendet, z. B. eine Mischung aus Helium und Argon. Der Druck beträgt im allgemeinen 1 bar, kann jedoch gegebenenfalls reduziert oder erhöht werden.

**Ansprüche**

1. Verfahren zum Herstellen von Einkristallen durch Verdunsten von Lösungsmitteln und/oder mittels Fällungsreaktionen, dadurch gekennzeichnet, daß der Einkristall aus einem, in einem stehenden Schall-oder Ultraschallfeld in der Schwebe gehaltenen Flüssigkeitstropfen berührungslos gezüchtet wird.

2. Verfahren nach Anspruch 1, dadurch gekennzeichnet, daß als Trägermedium für das stehende Schall-oder Ultraschallfeld Luft, Edelgase, vorzugsweise Helium und/oder Argon, oder eine mit dem Flüssigkeitstropfen nicht mischbare Flüssigkeit verwendet wird.

3. Verfahren nach Anspruch 1 oder 2, dadurch gekennzeichnet, daß durch eine Temperatur- und/oder Druckvariation im stehenden Schall-oder Ultraschallfeld und/oder durch direkte Erwärmung des Flüssigkeitstropfens unter Regelung der Übersättigungsverhältnisse die Kristallisation eingeleitet wird.

4. Verfahren nach Anspruch 3, dadurch gekennzeichnet, daß zur direkten Erwärmung des Flüssigkeitstropfens ein Laserstrahl eingesetzt wird, der den Flüssigkeitstropfen tangential berührt.

5. Verfahren nach einem der Ansprüche 1 bis 4, dadurch gekennzeichnet , daß bei Flüssigkeitstropfen, in denen die auszukristallisierende Substanz in geringer Konzentration vorliegt, das aus dem Tropfen verdunstende Lösungsmittel durch Nachliefern von weiterer Lösung ersetzt und damit in dem Tropfen die auszukristallisierende Substanz angereichert wird.

6. Verfahren nach einem der Ansprüche 1 bis 4, dadurch gekennzeichnet, daß bei Fällungsreaktionen eine Reaktionskomponente als Flüssigkeitstropfen im stehenden Schall-oder Ultraschallfeld positioniert wird und die andere Reaktionskomponente in das stehende Schall-oder Ultraschallfeld in gasförmiger oder flüssiger Phase zugeführt wird.

7. Verfahren nach Anspruch 6, dadurch gekennzeichnet, daß die andere Reaktionskomponente in flüssiger Phase mittels Kapillarwellenzerstäubung auf den Flüssigkeitstropfen aufgebracht wird.

8. Verfahren nach einem der Ansprüche 1 bis 7, dadurch gekennzeichnet , daß die als Tropfen zu positionierende Flüssigkeit vor der Einbringung in das stehende Schall-oder Ultraschallfeld entgast wird.

9. Verfahren nach einem der Ansprüche 1 bis 8, dadurch gekennzeichnet, daß die Kristallzüchtung unter Schwerelo sigkeit durchgeführt wird.

10. Vorrichtung zur Züchtung von Einkristallen zur Durchführung des Verfahrens nach Ansprüchen 1 bis 9, dadurch gekennzeichnet, daß sie aus einer Kammer (1) besteht, in der stehende Schall-oder Ultraschallfelder erzeugbar sind und die mit Einrichtungen (10) zur Einbringung eines im stehenden Schall-oder Ultraschallfeld zu positionierenden Flüssigkeitstropfens (2) versehen ist.

11. Vorrichtung nach Anspruch 10, dadurch gekennzeichnet, daß die Kammer (1) thermostatisiert ist.

12. Vorrichtung nach Anspruch 10 oder 11, dadurch gekennzeichnet, daß zur Variation des Lösungsmitteldampfdrucks in der Kammer (1) ein vorzugsweise separat beheizbares oder kühlbares Lösungsmittelreservoir (12) vorgesehen ist.

13. Vorrichtung nach einem der Ansprüche 10 bis 12, dadurch gekennzeichnet , daß zur Einstellung des Drucks in der Kammer (1) Drucksensoren (14) vorgesehen sind und daß der Lösungsmitteldampf aus der Kammer (1) kontrolliert abpumpbar (13) ist.

14. Vorrichtung nach einem der Ansprüche 10 bis 13, dadurch gekennzeichnet, daß in der Kammer (1) Sichtfenster zur Tropfenbeobachtung (8) und Einrichtungen (9) zur Beleuchtung des Kammerinnern vorgesehen sind.

15. Vorrichtung nach einem der Ansprüche 10 bis 14, dadurch gekennzeichnet, daß der Schall-oder Ultraschallgenerator (5) zur Reflektorabstimmung der stehenden Welle eine motorgetriebene, phasengesteuerte Abstandsregelung aufweist.

16. Vorrichtung nach einem der Ansprüche 10 bis 15, dadurch gekennzeichnet daß die Einrichtung (10) zur Einbringung des Flüssigkeitstropfens (2) in die stehende Welle aus einer vorzugsweise durch den Resonator (3) oder Reflektor (4) geführten Kanüle besteht.

17. Vorrichtung nach Anspruch 16, dadurch gekennzeichnet, daß die Kanüle (10) in axialer Richtung verschiebbar und/oder auswechselbar ist.

18. Vorrichtung nach einem der Ansprüche 10 bis 17, dadurch gekennzeichnet, daß eine Einrichtung (11) zur Absaugung des gezüchteten Einkristalls aus der stehenden Welle vorgesehen ist.

Vorrichtung nach Anspruch 18, dadurch gekennzeichnet, daß die Kanüle zur Flüssigkeitszuführung konzentrisch durch eine weitere Kanüle geführt ist, mittels der nach Entfernung der Kanüle zur Flüssigkeitszuführung der gezüchtete Einkristall absaugbar ist.